# DEMANDE DE BREVET EUROPEEN

(11) **EP 1 427 105 A2**
(43) Date de publication de la demande: **09.06.2004**
(21) Numéro de dépôt: 03300243.7
(22) Date de dépôt: 02.12.2003
(51) Int. Cl.: H03K 7/08

(54) **Générateur d'impulsions modulées en largeur**

(30) Priorité: 04.12.2002 FR 0215321
(71) Demandeur: STMicroelectronics S.A., 92120 Montrouge (FR)
(72) Inventeur: Florence, Arnaud, 37540 Saint Cyr sur Loire (FR); Heurtier, Jérôme, 37000 Tours (FR); Galtie, Franck, 37270 Veretz (FR)
(74) Mandataire: de Beaumont, Michel

(57) **Abrégé**

L'invention concerne un générateur d'au moins un signal (PWM) d'impulsions modulées en largeur comportant :
un générateur (31) d'un signal en dent de scie (SLOPE) ;
un générateur (36) de signaux de référence haut (S+) et bas (S-) définissant, à partir d'un signal de consigne (ERR ; Vdc), une plage linéaire de chaque rampe du signal en dent de scie ;
au moins un élément de comparaison (34, 35) du signal en dent de scie avec chacun des signaux de référence ; et
au moins un élément de combinaison logique (41) des résultats de comparaison, fournissant le signal d'impulsions.

## Description

La présente invention concerne la réalisation d'un générateur d'impulsions modulées en largeur.

Des signaux d'impulsions modulées en largeur sont utilisés dans de nombreuses applications, par exemple pour commuter un interrupteur de commande d'un convertisseur de tension continue-continue de type abaisseur ou élévateur de tension.

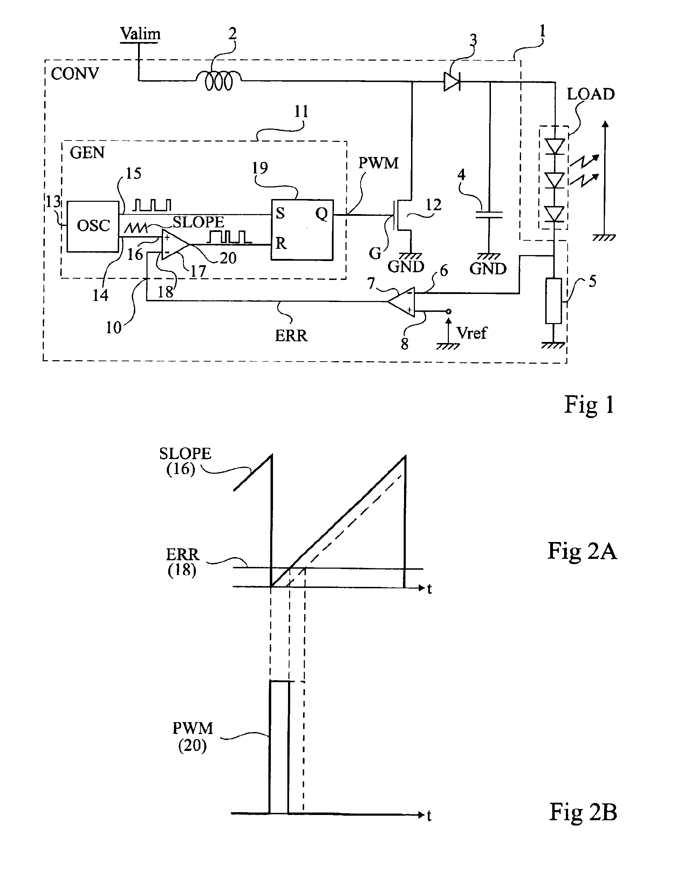

La figure 1 illustre un tel convertisseur élévateur (CONV) 1 destiné à fournir, à partir d'une tension d'alimentation continue Valim, une tension continue Vout supérieure à une charge LOAD. A titre d'exemple, on considère une charge LOAD aux bornes de laquelle la tension Vout est régulée à partir d'une consigne fonction d'une tension de référence Vref. Par exemple, la charge LOAD est constituée de diodes électroluminescentes d'un écran rétro-éclairé d'un téléphone portable.

Le convertisseur 1 comporte en série, entre un rail d'alimentation haute à la tension Valim et un rail de référence ou masse GND, une inductance 2, une diode 3 et un condensateur 4. La diode intermédiaire 3 est orientée de façon à permettre le passage d'un courant de l'inductance 2 vers le condensateur 4. Le point milieu de connexion de la cathode de la diode 3 et d'une armature du condensateur 4 constitue une borne de sortie du convertisseur 1 connectée à une extrémité de la charge LOAD. Une autre extrémité de la charge LOAD est connectée au rail de référence GND par une résistance de lecture 5 qui fait partie du convertisseur.

Pour réguler la tension Vout, le point milieu de la connexion de la charge LOAD et de la résistance 5 est connecté à une entrée inverseuse (-) 6 d'un amplificateur opérationnel 7 dont une entrée non-inverseuse (+) 8 reçoit la référence de tension continue Vref. Le signal d'erreur ERR de sortie de l'amplificateur 7 est fourni à une entrée de référence 10 d'un générateur d'impulsions (GEN) 11. La résistance 5 sert de convertisseur courant-tension.

Le générateur 11 fournit un signal d'impulsions modulées en largeur PWM à une borne de commande d'un interrupteur commandable 12, connecté entre l'anode de la diode 3 et le rail de référence GND. Généralement, l'interrupteur 12 est un transistor MOS dont la borne de commande est sa grille G.

Le générateur 11 comprend typiquement un oscillateur (OSC) 13 comportant deux sorties distinctes 14 et 15. Une sortie 14 de l'oscillateur 13 fournit un signal en dent de scie SLOPE à l'entrée non-inverseuse (+) 16 d'un comparateur 17. Une entrée inverseuse (-) 18 du comparateur 17 est connectée à la borne 10 et reçoit donc le signal d'erreur ERR fourni par l'amplificateur 7. L'autre borne de sortie 15 de l'oscillateur 13 fournit un train d'impulsions PULSE, de fréquence égale à la fréquence de la dent de scie SLOPE, à une entrée de mise à un S d'une bascule électronique de type RS 19. Une entrée de remise à zéro R de la bascule 19 est connectée à la sortie 20 du comparateur 17. La sortie Q de la bascule 19 constitue la sortie du générateur 11 et fournit le signal PWM à la grille G.

Le générateur 11 fournit donc un signal d'impulsions modulées en largeur PWM dont la référence de modulation ERR dépend de l'état de la différence de tension aux bornes de la résistance 5 du convertisseur 1 par rapport à une référence Vref. En pratique, le signal d'impulsions modulées PWM est fourni sur la sortie 20 du comparateur 17 et verrouillé par la bascule 19 de façon à obtenir une commande appropriée du transistor 12.

Les figures 2A et 2B sont des chronogrammes partiels et schématiques illustrant les signaux SLOPE, ERR et PWM de la figure 1. La figure 2A illustre un exemple de variation des signaux SLOPE et ERR en fonction du temps t. La figure 2B illustre le signal PWM sur la sortie 20 résultant de la comparaison du signal ERR et SLOPE de la figure 2A. Comme l'illustre la figure 2B, l'impulsions PWM apparaît au passage par zéro du signal SLOPE et disparaît lorsque ce signal devient égal au signal ERR.

Un inconvénient de ce type de circuit réside dans l'imprécision du rapport cyclique du signal PWM. En effet, l'oscillateur 13 ne fournit pas un signal en dent de scie parfait tel que le signal SLOPE de la figure 2A. Un oscillateur réel fournit un signal, illustré en pointillés en figure 2A, qui présente un décalage, généralement un retard, lors du passage par zéro. Alors, comme l'illustre également en pointillés la figure 2B, l'instant auquel le signal SLOPE devient réellement égal au signal de référence ERR est également décalé d'une erreur absolue existante sur toute la partie en rampe linéaire croissante du signal. Pour des valeurs de rapport cyclique du signal PWM relativement élevées, une telle erreur est négligeable. Par contre, pour de faibles valeurs du rapport cyclique, cette erreur absolue provoque un accroissement important du rapport cyclique du signal PWM.

Un autre inconvénient réside en ce que cette erreur est d'une valeur inconnue, incontrôlable notamment car elle dépend de dérives incontrôlables des procédés de fabrication et car elle peut varier en cours de fonctionnement du générateur.

Un autre inconvénient de ce circuit réside dans le fait que l'incertitude sur la valeur réelle du rapport cyclique est encore accrue par les retards de commutation des divers comparateurs (7, 17) du circuit. Ces retards sont d'autant plus grands que les valeurs comparées sont faibles (proches du niveau du rail de référence GND). L'accroissement est alors relativement plus important pour de faibles rapports cycliques que pour des rapports cycliques relativement élevés.

Un tel rapport cyclique de valeur accrue par rapport à une valeur nécessaire ou souhaitée pour une charge est particulièrement désavantageux dans le cas de dispositifs portables alimentés par batterie. En effet, le rapport cyclique correspondant à la puissance débitée par la batterie, si celui-ci est accru, la batterie se décharge plus rapidement qu'elle ne devrait.

Un objet de la présente invention est de proposer un générateur d'impulsions modulées en largeur dont le rapport cyclique soit connu avec précision, même pour de faibles valeurs.

Pour atteindre cet objet et d'autres, la présente invention prévoit un générateur d'au moins un signal d'impulsions modulées en largeur, comportant :
un générateur d'un signal en dent de scie ;
un générateur de signaux de référence haut et bas définissant, à partir d'un signal de consigne, une plage linéaire de chaque rampe du signal en dent de scie ;
au moins un élément de comparaison du signal en dent de scie avec chacun des signaux de référence ; et
au moins un élément de combinaison logique des résultats de comparaison, fournissant le signal d'impulsions.

Selon un mode de réalisation de l'invention, les signaux de référence sont symétriques par rapport à une valeur prédéterminée.

Selon un mode de réalisation de l'invention, la valeur prédéterminée est égale à la moitié de la valeur de tension maximale atteinte par le signal en dent de scie.

Selon un mode de réalisation de l'invention, le signal en dent de scie est de fréquence et d'amplitude fixes.

Selon un mode de réalisation de l'invention, le générateur comporte en outre une bascule de type RS dont une première entrée reçoit le signal de sortie de l'élément de combinaison et dont une seconde entrée reçoit directement un des signaux fournis par les éléments de comparaison.

Selon un mode de réalisation de l'invention, la première entrée de la bascule RS est l'entrée de mise à un et la seconde entrée est l'entrée de mise à zéro.

Selon un mode de réalisation de l'invention, l'élément de combinaison logique comprend au moins une porte de type OU-Exclusif ou une porte de type ET.

Selon un mode de réalisation de l'invention, le générateur des signaux de référence comporte un étage d'entrée recevant le signal de consigne et commandant un miroir de courant dont une branche de sortie fournit les signaux de référence.

Selon un mode de réalisation de l'invention, le miroir de courant comprend :
une branche d'entrée constituée d'une connexion en série, entre des rails d'alimentation haute et de référence, d'un premier transistor bipolaire de type PNP et d'un premier transistor de type NPN, la base du transistor de type PNP étant interconnectée à son collecteur ; et
la branche de sortie qui comporte une connexion en série, entre les rails haut et de référence, d'un second transistor de type PNP dont le collecteur fournit le signal de référence haut, de deux résistances et d'un second transistor de type NPN dont le collecteur fournit le signal de référence bas, les bases des transistors de type PNP étant interconnectées, le point milieu de connexion des résistances étant relié à la sortie d'un amplificateur opérationnel dont une entrée non-inverseuse reçoit la valeur prédéterminée, et dont une entrée inverseuse est interconnectée à sa sortie.

Selon un mode de réalisation de l'invention, le signal de consigne est un signal de régulation.

La présente invention prévoit également un convertisseur de tension continue-continue, du type élévateur ou abaisseur de tension, comportant un générateur selon l'un quelconque des modes de réalisation précédents pour commander un interrupteur de découpage d'une tension d'alimentation.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, qui a été décrite précédemment, illustre, schématiquement et partiellement, un convertisseur continu-continu de type élévateur de tension, utilisant un générateur d'impulsions modulées en largeur selon l'état de la technique ;
les figures 2A et 2B, qui ont été décrites précédemment, sont des chronogrammes illustrant des signaux prélevés en divers emplacements du circuit de la figure 1 ;
la figure 3 illustre, partiellement et schématiquement, un générateur d'impulsions modulées en largeur selon la présente invention ;
les figures 4A à 4D illustrent, sous forme de chronogrammes partiels et schématiques, des signaux prélevés en divers emplacements du circuit de la figure 3 ;
la figure 5 illustre, schématiquement et partiellement, un mode de réalisation d'un générateur de signaux de référence du circuit de la figure 3 ; et
la figure 6 illustre, schématiquement et partiellement, un autre mode de réalisation du générateur de signaux de référence de la figure 3.

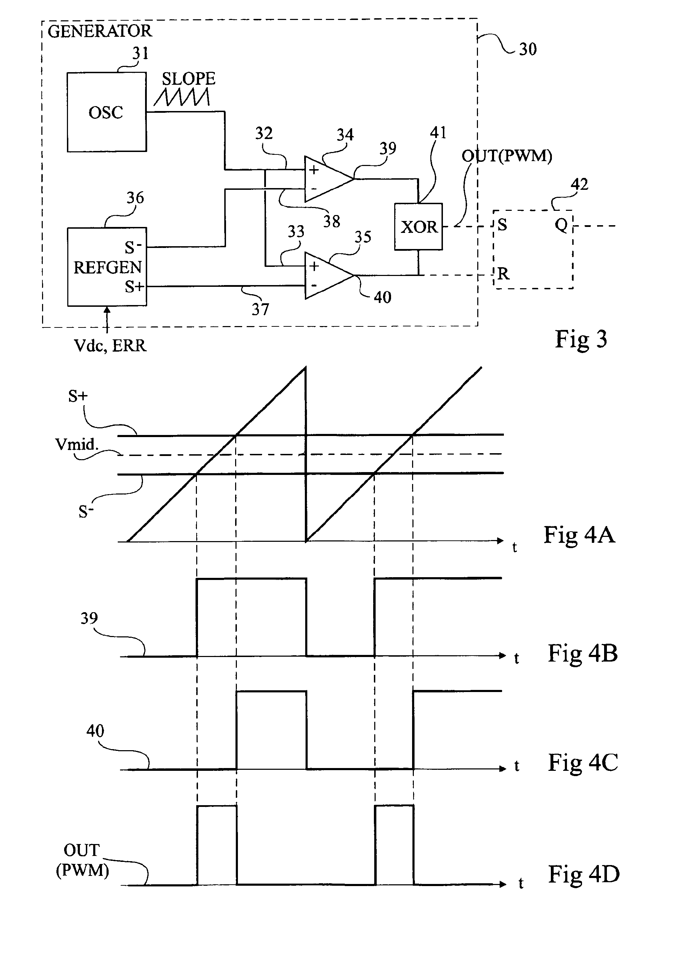

La figure 3 est un schéma-blocs fonctionnel et partiel d'un générateur (GENERATOR) 30 d'au moins un signal d'impulsions modulées en largeur selon la présente invention. Le générateur 30 comporte un oscillateur (OSC) 31 qui fournit un unique signal en dent de scie SLOPE à des entrées non-inverseuses (+) respectives 32 et 33 de deux comparateurs 34 et 35. Le signal SLOPE est préférentiellement de fréquence et d'amplitude fixes. Le générateur 30 comporte également un générateur (REFGEN) 36 de signaux de référence qui fournit deux signaux de référence, respectivement haut S+ et bas S-. Le signal haut S+ est fourni à une entrée inverseuse (-) 37 d'un quelconque des deux comparateurs, par exemple le comparateur 35. Le signal de référence bas S- est fourni à une entrée inverseuse (-) 38 de l'autre comparateur, par exemple le comparateur 34. La sortie respective 39, 40 de chaque comparateur 34 et 35 est fournie à une entrée respective d'un même élément de combinaison logique (XOR) 41 tel que, par exemple, une porte OU-Exclusif. La sortie OUT de l'élément de combinaison 41 constitue la sortie du générateur 30 et fournit un signal d'impulsions modulées en largeur (PWM). Le rapport cyclique dépend d'une consigne Vdc ou ERR fournie au générateur 36 et conditionnant les seuils S- et S+.

Les autres éléments représentés en figure 3 seront détaillés par la suite, après une brève description des principes de fonctionnement du générateur selon l'invention effectuée en relation avec les figures 4A, 4B, 4C et 4D.

Les figures 4A à 4D sont des chronogrammes illustrant, schématiquement et partiellement, des exemples de variation, en fonction du temps t des signaux SLOPE, S+, S- ; du signal à la sortie 39 du comparateur 34 ; du signal à la sortie 40 du comparateur 35 ; et du signal de sortie PWM sur le point OUT de la figure 3.

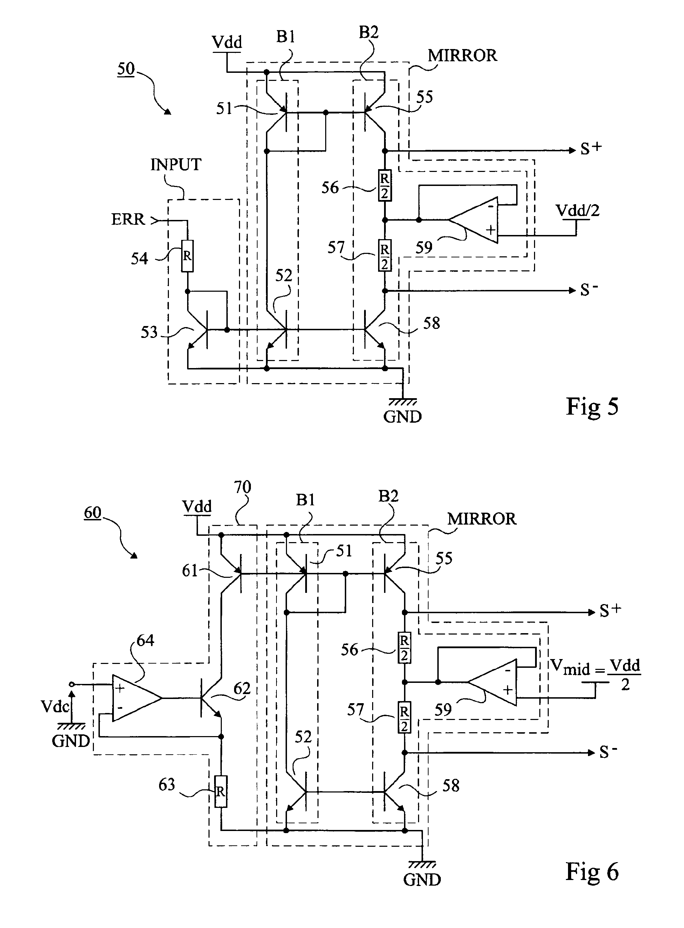

Selon la présente invention, les signaux de référence S- et S+ sont, comme cela sera détaillé en relation avec les figures 5 et 6, fixes en fonction d'une consigne donnée de façon à définir, comme l'illustre la figure 4A, une plage linéaire du signal SLOPE. Cette plage linéaire est centrée sur une tension intermédiaire prédéterminée Vmid. Les signaux de références S- et S+ sont des valeurs symétriques par rapport à la valeur Vmid. De façon similaire à ce qui a été décrit précédemment en relation avec le comparateur 17 de la figure 1, les comparateurs 34 et 35 de la figure 3 fournissent, sur leur sortie 39 et 40, des signaux illustrés respectivement en figure 4B et 4C qui sont à un niveau bas à compter du passage par zéro du signal SLOPE et qui passent à un état haut dès que le signal SLOPE dépasse la valeur de référence correspondante respective basse S- ou haute S+. Le signal PWM résultant à la sortie OUT de la porte OU-Exclusif XOR 41 est alors à l'état bas tant que le signal SLOPE est en dehors de la plage linéaire définie par les signaux de référence S- et S+ et est à l'état haut tant que le signal SLOPE parcourt la plage définie par les signaux de référence S- et S+. Le rapport cyclique du signal d'impulsions PWM obtenu est donc défini par la longueur de la plage fixée par les signaux de référence S- et S+, c'est-à-dire par l'écart les séparant.

En variante, une porte de type ET remplace la porte de type OU-Exclusif.

Un avantage de la présente invention est qu'un générateur selon la présente invention est insensible aux retards au passage par zéro. En effet, la valeur du rapport cyclique n'est plus fixée par le passage par une valeur absolue, mais par la longueur de la plage linéaire définie par les signaux de référence S- et S+. Ainsi, lors d'un retard au passage par zéro, le décalage résultant n'affecte pas le rapport cyclique du signal PWM, donc n'affecte pas la puissance fournie à la charge.

Un autre avantage de la présente invention est qu'en choisissant de façon appropriée la valeur Vmid, de préférence de l'ordre de la moitié de l'extension du signal SLOPE, un même générateur peut être utilisé pour alimenter des charges de n'importe quel type de rapport cyclique, faible ou élevé.

Un autre avantage de la présente invention réside en ce que, pour de faibles valeurs de rapport cyclique, le circuit est maintenant insensible aux bruits de masse. En effet, la commutation du signal PWM ne se produit plus sur une valeur proche de la valeur du rail de référence GND.

Un autre avantage de la présente invention est que l'oscillateur 31 utilisé ne doit plus fournir qu'un unique signal en dent de scie. Par rapport à un oscillateur (13, figure 1) d'un générateur d'impulsions (1) connu, il ne fournit plus le signal d'impulsions (PULSE). Cela simplifie la réalisation.

Un générateur d'impulsions modulées en largeur selon la présente invention est susceptible de très nombreuses applications. Par exemple, il peut être utilisé dans des convertisseurs continu-continu de type élévateur ou abaisseur de tension dans des dispositifs portables tels que des téléphones, des organiseurs, des ordinateurs personnels portables.

Dans certaines telles applications, il peut toutefois être nécessaire de disposer d'un signal synchrone comme cela a été décrit précédemment en relation avec la figure 1.

Comme l'illustre la figure 3 en pointillés, le générateur 30 selon l'invention peut alors être complété par l'adjonction d'un étage de sortie constitué par une bascule électronique RS 42. Une entrée, par exemple de mise à un S, de la bascule 42 est connectée à la sortie OUT du générateur 30. L'autre entrée de la bascule 42, par exemple de remise à zéro R, est connectée à une sortie 39 ou 40 d'un des comparateurs 34 et 35. La sortie Q de la bascule 42 constitue alors la sortie réelle du générateur d'impulsions.

Dans le cas du mode de réalisation de la figure 3 utilisant comme élément de combinaison 41 une porte OU-Exclusif, l'entrée de mise à zéro R de la bascule 42 est, de préférence, connectée à la sortie 40 du comparateur 35 recevant le signal de référence haut S+. Ainsi, la bascule transmet la totalité du signal PWM. Connecter à l'entrée R la sortie 39 du comparateur 34 recevant le signal de référence bas S- permettrait toutefois d'obtenir un autre signal d'impulsions, correspondant au signal de sortie de ce même comparateur 34, illustré en figure 4B. Il est ainsi également possible de réaliser un générateur de plusieurs signaux modulés en largeur.

Il est également possible de fournir les signaux de sortie 39 et 40 des comparateurs 34 et 35 à plusieurs éléments de combinaison distincts, et obtenir ainsi plusieurs signaux de rapports cycliques différents.

Selon l'invention, la réalisation pratique du générateur REFGEN (36, figure 3) des signaux de référence haut S+ et bas S- dépend de la nature de la consigne à partir de laquelle ils sont produits. Les figures 5 et 6 illustrent, partiellement et schématiquement, deux modes de réalisation du générateur REFGEN.

La figure 5 illustre un générateur 50 de signaux de référence utilisable selon la présente invention dans une application similaire à celle de la figure 1, dans laquelle la consigne à partir de laquelle sont produits les signaux de référence S- et S+ varie à partir d'une contre-réaction sur la charge alimentée par le générateur, par exemple au moyen d'un amplificateur d'erreur de contre-réaction similaire à l'amplificateur d'erreur 7 de la figure 1.

Le générateur 50 comprend alors, entre un rail d'alimentation haute Vdd et le rail de référence GND, un miroir de courant MIRROR. Une branche d'entrée B1 du miroir de courant est constituée de la connexion en série, entre les rails Vdd et de référence GND, d'un transistor bipolaire de type PNP 51 et d'un transistor de type NPN 52. La base du transistor 51 est interconnectée à son collecteur (et donc au collecteur du transistor 52). La base du transistor 52 est connectée à la sortie d'un étage d'entrée INPUT constitué par la base d'un transistor 53 de type NPN. L'émetteur du transistor 53 est connecté au rail de référence GND. Le collecteur du transistor 53, interconnecté à sa base, reçoit un signal de consigne variable ERR, de préférence par l'intermédiaire d'une résistance 54 de valeur R.

Une branche de sortie B2 du miroir MIRROR est constituée par la connexion, en série entre les mêmes rails Vdd et GND, d'un transistor de type PNP 55, de deux résistances 56 et 57 et d'un transistor de type NPN 58. La base du transistor 55 est connectée à la base du transistor 51. L'émetteur du transistor 58 est interconnecté à l'émetteur du transistor 52 connecté au rail de référence GND. Les valeurs des résistances 56 et 57 sont, de préférence, égales. De préférence, elles valent chacune la moitié de la valeur R de la résistance 54 de l'étage d'entrée INPUT. Dans le cas où la résistance 54 est omise (par exemple si la consigne ERR est fournie par une source de courant), les résistances 56 et 57 sont, de préférence, égales chacune à la moitié de l'impédance d'entrée de l'étage INPUT.

Le point milieu de connexion des résistances 56 et 57 est relié à la sortie d'un amplificateur opérationnel 59 dont une entrée non-inverseuse (+) reçoit, comme valeur de référence, la valeur prédéterminée Vmid, égale ici à la moitié du niveau de tension Vdd présent sur le rail d'alimentation haute. L'entrée inverseuse (-) de l'amplificateur 59 est interconnectée à sa sortie. Ainsi, le point milieu des résistances 56 et 57 de la branche de sortie B2 est verrouillé, stabilisé à la valeur prédéterminée Vmid. Le collecteur du transistor 55 fournit le signal de référence haut S+ et le collecteur du transistor 58 fournit le signal de référence bas S-.

La valeur du signal haut S+ est égale à la somme de la valeur prédéterminée Vmid et de la chute de tension aux bornes de la résistance 56. Par contre, la valeur du signal bas S- est égale à la différence entre la valeur prédéterminée Vmid et la chute de tension aux bornes de la résistance 57. Or, les valeurs des chutes de tension respectives aux bornes des résistances 56 et 57 sont égales au produit du courant parcourant la branche de sortie B2 et de la valeur respective de chacune des résistances 56, 57. Comme le courant I parcourant la branche de sortie B2 est la copie du courant I parcourant la branche d'entrée B1, ce courant I dépend de la commande de base des transistors PNP 51 et 55, qui dépend de la valeur de la consigne ERR de l'étage d'entrée INPUT. Les valeurs S- et S+ dépendent donc de la valeur de consigne ERR. En outre, avec des valeurs des résistances 56 et 57 égales, les valeurs S- et S+ sont symétriques par rapport à la valeur prédéterminée Vmid.

On notera que, même si les seuil S- et S+ n'évoluent pas de façon exactement linéaire par rapport à la consigne ERR, cela n'est pas gênant, car il s'agit alors d'une erreur absolue qui ne varie pas au cours du fonctionnement, comme cela était le cas pour du bruit. De plus, cette erreur est si besoin maîtrisable par l'accord des composants (transistors, résistances, etc.) lors de la fabrication.

La figure 6 illustre un autre mode de réalisation d'un générateur des signaux de référence S- et S+ utilisable, par exemple, pour délivrer un signal dont la modulation en largeur, c'est-à-dire le rapport cyclique, est constante. Le générateur 60 de la figure 6 se distingue du générateur 50 de la figure 5 uniquement par l'étage d'entrée 70 dont la structure et la connexion sont différentes. L'étage d'entrée 70 du générateur 60 comporte, entre les rails d'alimentation Vdd et GND, une connexion en série d'un transistor de type PNP 61, d'un transistor de type NPN 62 et d'une résistance 63 d'une valeur R. La base du transistor 61 constitue la sortie de l'étage d'entrée 70 et est reliée aux bases des transistors de type PNP 51 et 55 du miroir MIRROR. L'émetteur du transistor 62, c'est-à-dire le point milieu de la connexion en série du transistor 62 et de la résistance 63, est connecté à l'entrée inverseuse (-) d'un amplificateur opérationnel 64 dont une entrée non-inverseuse (+) reçoit une consigne de tension continue Vdc. La sortie de l'amplificateur 64 est reliée à la base du transistor 62.

De préférence, tant pour le générateur 50 de la figure 5 que pour le générateur 60 de la figure 6, le niveau de tension Vdd présent sur le rail d'alimentation haute est égal à la valeur de tension maximale atteinte par le signal en dent de scie SLOPE. Ainsi, les signaux de référence S- et S+ sont centrés sur le milieu de ce signal SLOPE, la plage linéaire qu'ils définissent peut alors varier de toute l'amplitude du signal SLOPE et donc le rapport cyclique de 0 à 100%.

On notera que le générateur 60 de la figure 6 peut aussi servir en régulation, la consigne ERR étant appliquée à la place de la tension Vdc. De même, le générateur 50 de la figure 5 peut recevoir une consigne fixe Vdc (non issue d'une contre-réaction).

Bien entendu, la présente invention est susceptible de diverses variantes et modifications qui apparaîtront à l'homme de l'art.

En particulier, la présente invention est susceptible de très nombreuses applications. Ainsi, des convertisseurs continu-continu sont utilisables comme alimentation de nombreux dispositifs tels que des appareils portables, par exemple, des téléphones, des organiseurs ou des ordinateurs. Par exemple, ils sont également utilisés dans des gradateurs d'intensité lumineuse.

De plus, l'oscillateur 31 de production du signal en dent de scie SLOPE pourra être de fréquence et/ou d'amplitude variable et pourra bien entendu être inversé, c'est-à-dire à rampes décroissantes.

En outre, les comparateurs 34, 35 ou les amplificateurs opérationnels 59, 64 représentés aux différentes figures peuvent être remplacés par tout élément réalisant une même fonction.

## Revendications

1. Générateur d'au moins un signal (PWM) d'impulsions modulées en largeur, **caractérisé en ce qu'**il comporte :
un générateur (31) d'un signal en dent de scie (SLOPE) ;
un générateur (36 ; 50 ; 60) de signaux de référence haut (S+) et bas (S-) définissant, à partir d'un signal de consigne (ERR ; Vdc), une plage linéaire de chaque rampe du signal en dent de scie ;
au moins un élément de comparaison (34, 35) du signal en dent de scie avec chacun des signaux de référence ; et
au moins un élément de combinaison logique (41) des résultats de comparaison, fournissant ledit signal d'impulsions.

2. Générateur selon la revendication 1, **caractérisé en ce que** lesdits signaux de référence (S-, S+) sont symétriques par rapport à une valeur prédéterminée (Vmid).

3. Générateur selon la revendication 2, **caractérisé en ce que** la valeur prédéterminée (Vmid) est égale à la moitié de la valeur de tension maximale atteinte par le signal en dent de scie (SLOPE).

4. Générateur selon l'une quelconque des revendications 1 à 3, **caractérisé en ce que** le signal en dent de scie (SLOPE) est de fréquence et d'amplitude fixes.

5. Générateur selon l'une quelconque des revendications 1 à 4, **caractérisé en ce qu'**il comporte en outre une bascule de type RS (42) dont une première entrée (S) reçoit le signal de sortie (PWM) dudit élément de combinaison (41) et dont une seconde entrée (R) reçoit directement un des signaux fournis par lesdits éléments de comparaison (35).

6. Générateur selon la revendication 5, **caractérisé en ce que** la première entrée est l'entrée de mise à un (S) et la seconde entrée est l'entrée de mise à zéro (R).

7. Générateur selon l'une quelconque des revendications 1 à 6, **caractérisé en ce que** ledit élément de combinaison logique (41) comprend au moins une porte de type OU-Exclusif (XOR) ou une porte de type ET.

8. Générateur selon l'une quelconque des revendications 1 à 7, **caractérisé en ce que** le générateur (50 ; 60) des signaux de référence (S-, S+) comporte un étage d'entrée (INPUT ; 70) recevant ledit signal de consigne (ERR ; Vdc) et commandant un miroir de courant (MIRROR) dont une branche de sortie (B2) fournit lesdits signaux de référence.

9. Générateur selon la revendication 8 dans son rattachement à la revendication 2, **caractérisé en ce que** le miroir de courant (MIRROR) comprend :
une branche d'entrée (B1) constituée d'une connexion en série, entre des rails d'alimentation haute (Vdd) et de référence (GND), d'un premier transistor bipolaire de type PNP (51) et d'un premier transistor de type NPN (52), la base du transistor de type PNP étant interconnectée à son collecteur ; et
ladite branche de sortie (B2) qui comporte une connexion en série, entre lesdits rails haut et de référence, d'un second transistor de type PNP (55) dont le collecteur fournit le signal de référence haut (S+), de deux résistances (56, 57) et d'un second transistor de type NPN (58) dont le collecteur fournit le signal de référence bas (S-), les bases des transistors de type PNP étant interconnectées, le point milieu de connexion desdites résistances étant relié à la sortie d'un amplificateur opérationnel (59) dont une entrée non-inverseuse (+) reçoit ladite valeur prédéterminée (Vmid), et dont une entrée inverseuse (-) est interconnectée à sa sortie.

10. Générateur selon l'une quelconque des revendications 5 à 9, **caractérisé en ce que** ledit signal de consigne (ERR) est un signal de régulation.

11. Convertisseur de tension continue-continue, du type élévateur ou abaisseur de tension, **caractérisé en ce qu'**il comporte un générateur selon l'une quelconque des revendications 1 à 10 pour commander un interrupteur (12) de découpage d'une tension d'alimentation (Valim).
